# EUROPEAN PATENT APPLICATION

(11) **EP 2 278 635 A2**
(43) Date of publication of application: **26.01.2011**
(21) Application number: 08022018.9
(22) Date of filing: 18.12.2008
(51) Int. Cl.: H01L 45/00

(54) **Method of making memory with resistivity changing material**

(30) Priority: 16.01.2008 US 14960
(71) Applicant: Qimonda AG, 81739 München (DE)
(72) Inventor: Baier, Ulrich, 01307 Dresden (DE); Schmidbauer, Sven, 01099 Dresden (DE)

(57) **Abstract**

A method of manufacturing a memory cell includes: forming a first electrode, depositing a first insulator material over the first electrode, forming a via in the first insulator material, depositing a resistivity changing material in the via without completely filling the via, and forming a second electrode contacting the resistivity changing material.

## Description

### Background

One type of memory is resistive memory. Resistive memory utilizes the resistance value of a memory element to store one or more bits of data. For example, a memory element programmed to have a high resistance value may represent a logic "1" data bit value and a memory element programmed to have a low resistance value may represent a logic "0" data bit value. Typically, the resistance value of the memory element is switched electrically by applying a voltage pulse or a current pulse to the memory element.

One type of resistive memory is phase change memory. Phase change memory uses a phase change material in the resistive memory element. The phase change material exhibits at least two different states. The states of the phase change material may be referred to as the amorphous state and the crystalline state, where the amorphous state involves a more disordered atomic structure and the crystalline state involves a more ordered lattice. The amorphous state usually exhibits higher resistivity than the crystalline state. Also, some phase change materials exhibit multiple crystalline states, e.g., a face-centered cubic (FCC) state and a hexagonal closest packing (HCP) state, which have different resistivities and may be used to store bits of data. In the following description, the amorphous state generally refers to the state having the higher resistivity and the crystalline state generally refers to the state having the lower resistivity.

Phase changes in the phase change materials may be induced reversibly. In this way, the memory may change from the amorphous state to the crystalline state and from the crystalline state to the amorphous state in response to temperature changes. The temperature changes of the phase change material may be achieved by driving current through the phase change material itself or by driving current through a resistive heater adjacent the phase change material. With both of these methods, controllable heating of the phase change material causes controllable phase change within the phase change material.

A phase change memory can include a memory array having a plurality of memory cells that are made of phase change material and are programmable to store data utilizing the memory states of the phase change material. One way to read and write data in such a phase change memory device is to control a current and/or a voltage pulse that is applied to the phase change material. The temperature in the phase change material in each memory cell generally corresponds to the applied level of current and/or voltage to achieve the heating.

To achieve higher density phase change memories, a phase change memory cell can store multiple bits of data. Multi-bit storage in a phase change memory cell can be achieved by programming the phase change material to have intermediate resistance values or states, where the multi-bit or multilevel phase change memory cell can be written to more than two states. If the phase change memory cell is programmed to one of three different resistance levels, 1.5 bits of data per cell can be stored. If the phase change memory cell is programmed to one of four different resistance levels, two bits of data per cell can be stored, and so on. To program a phase change memory cell to an intermediate resistance value, the amount of crystalline material coexisting with amorphous material and hence the cell resistance is controlled via a suitable write strategy.

The trend to miniaturize semiconductor devices drives the technology development to smaller feature sizes and to shrinkage of critical dimensions. In addition, for reliable operation of phase change memory cells it is desirable, that the contact area of the phase change material to an ohmic heater element is as small as possible to reduce the required heater current. These demands can be addressed by structuring vias of sub-lithographic dimensions in an insulator layer, landing on a larger heater layer. The vias are filled with phase change material. The control of the filling of these vias with decreasing dimensions is getting more and more challenging. Issues like void formation, incomplete filling behavior, etc. arise during filling of small structures like sub-lithographic vias preventing to build conventional phase change memory elements.

It would be desirable to have phase change element memories still implementing the via fill approach for future technologies with decreased feature sizes.

### Summary

A method of manufacturing a memory cell includes: forming a first electrode, depositing a first insulator material over the first electrode, forming a via in the first insulator material, depositing a resistivity changing material in the via without completely filling the via, and forming a second electrode contacting the resistivity changing material.

### Brief Description of the Drawings

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description. The elements of the drawings are not necessarily to scale relative to each other. Like reference numerals designate corresponding similar parts.
Figure 1 is a block diagram illustrating an embodiment of a system including a memory device.
Figure 2 is a diagram illustrating an embodiment of a memory device.
Figure 3 illustrates a cross-sectional view of a first embodiment of a phase change memory element.
Figure 4 illustrates a cross-sectional view of the first embodiment after depositing a first insulator material and after forming a via in the first insulator material.
Figure 5 illustrates a cross-sectional view of the first embodiment after depositing phase change material in the via without completely filling the via.
Figure 6 illustrates a cross-sectional view of the first embodiment after depositing a first liner material over the phase change material.
Figure 7 illustrates a cross-sectional view of the first embodiment after removing a portion of the first liner material and a portion of the phase change material.
Figure 8 illustrates a cross-sectional view of the first embodiment after depositing a second insulator material and mask material and after structuring the mask material.
Figure 9 illustrates a cross-sectional view of a second embodiment after depositing and structuring a sacrificial material.
Figure 10 illustrates a cross-sectional view of the second embodiment after depositing a second liner material.
Figure 11 illustrates a cross-sectional view of the second embodiment after removing a portion of the second liner material and a portion of a second insulator material.
Figure 12 illustrates a cross-sectional view of the second embodiment after removing the sacrificial material.
Figure 13 illustrates a cross-sectional view of the second embodiment after depositing a conductor material.
Figure 14 illustrates a cross-sectional view of a third embodiment after depositing a conductor material and after depositing and structuring of a mask material.
Figure 15 illustrates a cross-sectional view of the third embodiment after removing a portion of a second liner material and a portion of a second insulator material.
Figure 16 is a functional flow diagram illustrating an embodiment of a method of manufacturing a memory cell.

### Detailed Description

In the following detailed description, reference is made to the accompanying drawings, which form a part hereof, and in which is shown by way of illustration specific embodiments in which the invention may be practiced. In this regard, directional terminology, such as "top", "bottom", "front", "back", "over", "under", "above", "leading", "trailing", etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, therefore, is not to be taken in a limiting sense, and the scope of the present invention is defined by the appended claims.

It is to be understood that the features of the various embodiments described herein may be combined with each other, unless specifically noted otherwise.

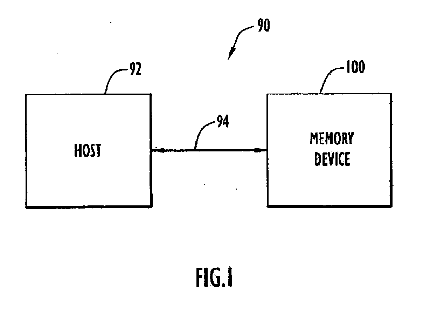

Figure 1 is a block diagram illustrating an embodiment of a system 90 that includes a host 92 and a memory device 100. Host 92 is communicatively coupled to memory device 100 through communication link 94. Host 92 can be any of a wide variety of devices including but not limited to a computer (e.g., desktop, laptop, handheld), portable electronic device (e.g., cellular phone, personal digital assistant (PDA), MP3 player, video player, digital camera), or any other suitable device that uses memory. Memory device 100 provides memory for host 92. In another embodiment, memory device 100 includes a resistivity changing memory device which can be or a phase change memory device or a magnetic memory device, for example.

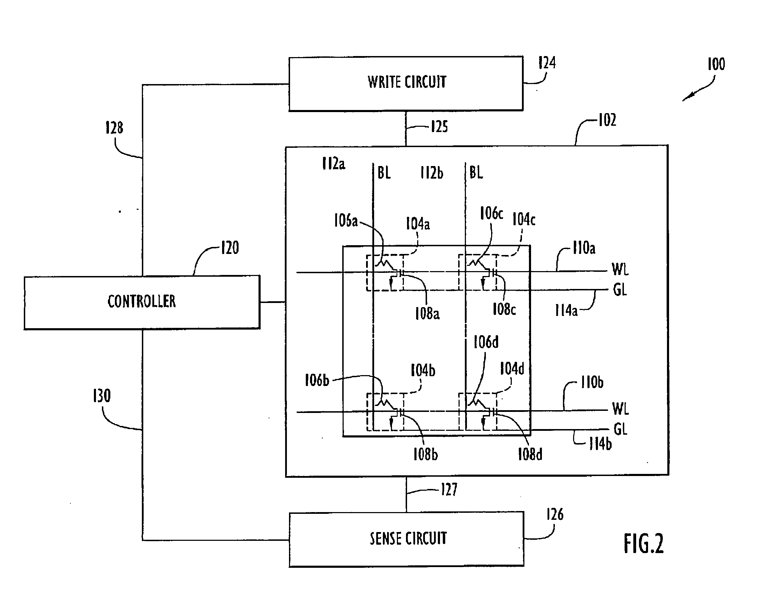

Figure 2 is a diagram illustrating an embodiment of memory device 100. In an embodiment, memory device 100 is an integrated circuit or part of an integrated circuit. Memory device 100 includes a write circuit 124, a controller 120, a memory array 102, and a sense circuit 126. Memory array 102 includes a plurality of resistivity changing memory cells 104a-104d (collectively referred to as resistive memory cells 104), a plurality of bit lines (BLs) 112a-112b (collectively referred to as bit lines 112), a plurality of word lines (WLs) 110a-110b (collectively referred to as word lines 110), and a plurality of ground lines (GLs) 114a-114b (collectively referred to as ground lines 114). In an embodiment, resistivity changing memory cells 104 are phase change memory cells. In other embodiments, resistivity changing memory cells 104 are another suitable type of resistivity changing memory cells, such as magnetic memory cells.

As used herein, the term "electrically coupled" is not meant to mean that the elements must be directly coupled together and intervening elements may be provided between the "electrically coupled" elements.

Memory array 102 is electrically coupled to write circuit 124 through signal path 125, to controller 120 through signal path 121, and to sense circuit 126 through signal path 127. Controller 120 is electrically coupled to write circuit 124 through signal path 128 and to sense circuit 126 through signal path 130. Each phase change memory cell 104 is electrically coupled to a word line 110 and a bit line 112. Phase change memory cell 104a is electrically coupled to bit line 112a and word line 110a, and phase change memory cell 104b is electrically coupled to bit line 112a and word line 110b. Phase change memory cell 104c is electrically coupled to bit line 112b and word line 110a, and phase change memory cell 104d is electrically coupled to bit line 112b and word line 110b.

Each phase change memory cell 104 is electrically coupled to a word line 110, a bit line 112, and a ground line 114, For example, phase change memory cell 104a is electrically coupled to bit line 112a, word line 110a, and ground line 114a, and phase change memory cell 104b is electrically coupled to bit line 112a, word line 110b, and ground line 114b. Phase change memory cell 104c is electrically coupled to bit line 112b, word line 110a, and ground line 114a, and phase change memory cell 104d is electrically coupled to bit line 112b, word line 110b, and ground line 114b.

Each phase change memory cell 104 includes a phase change memory element 106 and a select device 108. While select device 108 is a field-effect transistor (FET) in the illustrated embodiment, the select device 108 can be other suitable devices such as a bipolar transistor or a 3D transistor structure. In other embodiments, a diode-like structure may be used in place of transistor 108. In this case, a diode and phase change element 106 is coupled in series between each cross point of word lines 110 and bit lines 112.

Phase change memory cell 104a includes phase change memory element 106a and transistor 108a. One side of phase change memory element 106a is electrically coupled to bit line 112a and the other side of phase change memory element 106a is electrically coupled to one side of the source-drain path of transistor 108a. The other side of the source-drain path of transistor 108a is electrically coupled to ground line 114a. The gate of transistor 108a is electrically coupled to word line 110a.

Phase change memory cell 104b includes phase change memory element 106b and transistor 108b. One side of phase change memory element 106b is electrically coupled to bit line 112a and the other side of phase change memory element 106b is electrically coupled to one side of the source-drain path of transistor 108b. The other side of the source-drain path of transistor 108b is electrically coupled to ground line 114b. The gate of transistor 108b is electrically coupled to word line 110b.

Phase change memory cell 104c includes phase change memory element 106c and transistor 108c. One side of phase change memory element 106c is electrically coupled to bit line 112b and the other side of phase change memory element 106c is electrically coupled to one side of the source-drain path of transistor 108c. The other side of the source-drain path of transistor 108c is electrically coupled to ground line 114a. The gate of transistor 108c is electrically coupled to word line 110a.

Phase change memory cell 104d includes phase change memory element 106d and transistor 108d. One side of phase change memory element 106d is electrically coupled to bit line 112b and the other side of phase change memory element 106d is electrically coupled to one side of the source-drain path of transistor 108d. The other side of the source-drain path of transistor 108d is electrically coupled to ground line 114b. The gate of transistor 108d is electrically coupled to word line 110b.

In an embodiment, each resistivity changing memory element 106 is a phase change memory element that comprises a phase change material that may be made up of a variety of materials. Generally, chalcogenide alloys that contain one or more elements from Group VI of the periodic table are useful as such materials. In an embodiment, the phase change material is made up of a chalcogenide compound material, such as GeSbTe, SbTe, GeTe, or AgInSbTe. In one embodiment, the phase change material is chalcogen free, such as GeSb, GaSb, InSb, or GeGaInSb. In other embodiments, the phase change material is be made up of any suitable material including one or more of the elements Ge, Sb, Te, Ga, As, In, Se, and S.

However, it will be appreciated that the invention is not limited to any particular material or classes of materials, and virtually any substance capable of being configured in plural resistivity states can be employed.

According to an embodiment, each phase change memory element may be changed from an amorphous state to a crystalline state or from a crystalline state to an amorphous state under the influence of temperature change. The amount of crystalline material coexisting with amorphous material in the phase change material of one of the phase change memory elements thereby defines two or more states for storing data within memory device 100. In the amorphous state, a phase change material exhibits significantly higher resistivity than in the crystalline state. Therefore, the two or more states of the phase change memory elements differ in their electrical resistivity. In an embodiment, the two or more states are two states and a binary system is used, wherein the two states are assigned bit values of "0" and "1". In another embodiment, the two or more states are three states and a ternary system is used, wherein the three states are assigned bit values of "0", "1", and "2". In another embodiment, the two or more states are four states that are assigned multi-bit values, such as "00", "01", "10", and "11". In other embodiments, the two or more states are another suitable number of states in the phase change material of a phase change memory element.

Controller 120 includes a microprocessor, microcontroller, or other suitable logic circuitry for controlling the operation of memory device 100. Controller 120 controls read and write operations of memory device 100 including the application of control and data signals to memory array 102 through write circuit 124 and sense circuit 126. In an embodiment, write circuit 124 provides voltage pulses through signal path 125 and bit lines 112 to memory cells 104 to program the memory cells. In another embodiment, write circuit 124 provides current pulses through signal path 125 and bit lines 112 to memory cells 104 to program the memory cells.

Sense circuit 126 reads each of the two or more states of memory cells 104 through bit lines 112 and signal path 127. In an embodiment, to read the resistance of one of the memory cells 104, sense circuit 126 provides current that flows through one of the memory cells 104. Sense circuit 126 then reads the voltage across that one of the memory cells 104. In another embodiment, sense circuit 126 provides voltage across one of the memory cells 104 and reads the current that flows through that one of the memory cells 104. In another embodiment, write circuit 124 provides voltage across one of the memory cells 104 and sense circuit 126 reads the current that flows through that one of the memory cells 104. In another embodiment, write circuit 124 provides current that flows through one of the memory cells 104 and sense circuit 126 reads the voltage across that one of the memory cells 104.

During a "set" operation of phase change memory cell 104a, a set current or voltage pulse is selectively enabled by write circuit 124 and sent through bit line 112a to phase change memory clement 106a, thereby heating phase change memory element 106a above its crystallization temperature (but usually below its melting temperature). In this way, phase change memory element 106a reaches its crystalline state or a partially crystalline and partially amorphous state during this set operation.

During a "reset" operation of phase change memory cell 104a, a reset current or voltage pulse is selectively enabled by write circuit 124 and sent through bit line 112a to phase change memory element 106a. The reset current or voltage quickly heats phase change memory element 106a above its melting temperature. After the currcnt or voltage pulse is turned off, phase change memory element 106a quickly quench cools into the amorphous state or a partially amorphous and partially crystalline state.

Phase change memory cells 104b-104d and other phase change memory cells 104 in memory array 102 are set and reset similarly to phase change memory cell 104a using a similar current or voltage pulse. In other embodiments, for other types of resistive memory cells, write circuit 124 provides suitable programming pulses to program the resistivity changing memory cells 104 to the desired state.

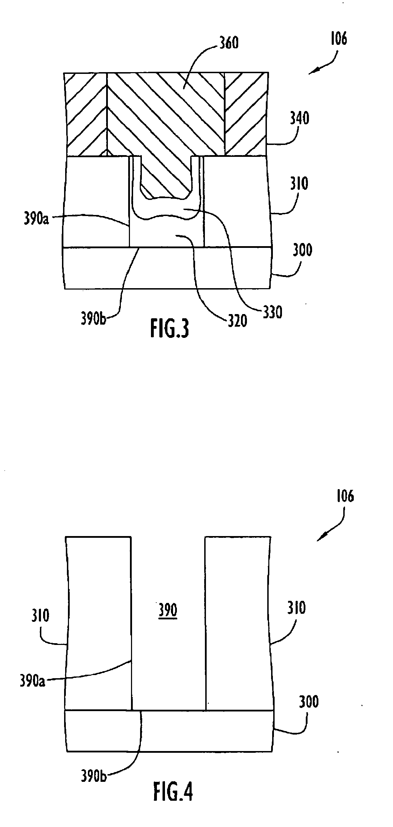

Figure 3 illustrates a cross-sectional view of a first embodiment of phase change memory element 106. Phase change memory element 106 includes a first electrode 300, an insulator material 310 with a via 390 (see the unfilled via 390 in Figure 4), phase change material 320 contacting the via bottom 390b and the via sidewalls 390a, and a second electrode 360 extending into via 390. During deposition of phase change material 320 in via 390, a void is formed extending into via 390. The void is filled with conductor material to form second electrode 360 extending into via 390.

In another implementation, phase change memory element 106 includes further a first liner material 330 deposited over phase change material 320. In one implementation, first liner material 330 includes at least one of Ti, TiN, or TaN. Other implementations for first liner material 330 include any other suitable liner material.

The following Figures 4-8 illustrate the first embodiment for manufacturing phase change memory element 106 as illustrated and described with reference to Figure 3.

Figure 4 illustrates a cross-sectional view of the first embodiment after depositing first insulator material 310 and after forming via 390 in first insulator material 310. The term "via" means that the opening goes all the way through the material. Via 390 extends through insulator material 310.

In one implementation, first electrode 300 is formed by depositing using chemical vapor deposition (CVD), high density plasma-chemical vapor deposition (HDP-CVD), atomic layer deposition (ALD), metal organic chemical vapor deposition (MOCVD), physical vapor deposition (PVD), jet vapor deposition (JVD), or other suitable deposition technique. First electrode 300 includes TiN, TaN, W, Al, Ti, Ta, TiSiN, TaSiN, TiAlN, TaAlN, Cu, WN, C, or other suitable conductor material.

First electrode 300 is formed over a substrate which is not illustrated. The substrate includes Si substrate, Si on insulator (SOI) substrate, or other suitable substrate. In one implementation, the substrate is pre-processed and includes select devices or other devices. In one implementation, the substrate includes select devices 108, such as transistors of any type (e.g., FET or bipolar transistors) or diodes. In another implementation, the substrate includes other suitable devices for semiconductor manufacturing like buried lines, etc.

First insulator material 310 is deposited using CVD, HDP-CVD, ALD, MOCVD, PVD, JVD, or other suitable deposition technique. Insulator material 310 includes SiO₂ SiOₓ, SiN, fluorinated silica glass (FSG), boro-phosphorous silicate glass (BPSG), boro-silicate glass (BSG), or other suitable insulator material.

Via 390 can be formed by etching. In one implementation, a mask can be used for protecting parts of the underlying material which should not be removed. The mask includes resists, anti-reflective coatings (ARC), hard masks, or other suitable mask materials. In another implementation, resolution enhancing techniques are applied to structure via 390 with sub-lithographic resolution. Etching via 390 includes plasma etching or wet etching processes for example. Via sidewalls 390a could be angled or parallel (as illustrated in the Figures). In one implementation, the aspect-ratio of via 390 is greater than 1.5.

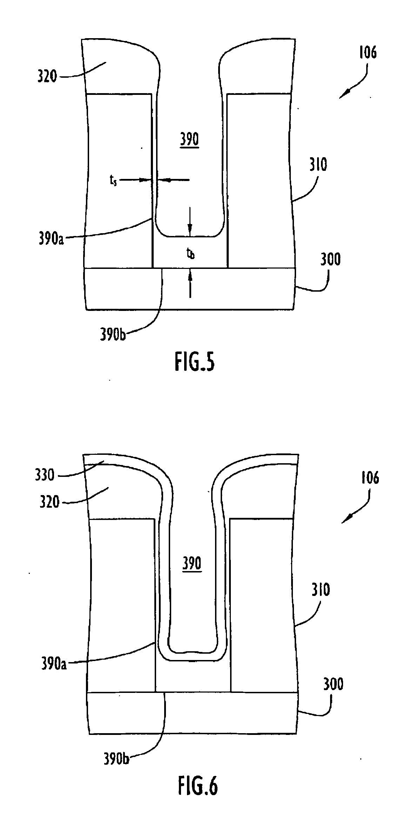

Figure 5 illustrates a cross-sectional view of the first embodiment after depositing phase change material 320 in via 390 without completely filling via 390. Phase change material 320 is electrically coupled to first electrode 300.

Phase change material 320 includes at least one of the aforementioned phase change materials, material compositions, or material alloys. Phase change material 320 is deposited using CVD, HDP-CVD, ALD, MOCVD, PVD, JVD, or other suitable deposition technique. During deposition of phase change material 320 in via 390 a void is formed. In one implementation, the thicknesses of phase change material 320 at the bottom of via 390 *t_{b}* and at the sidewalls of via 390 *tₛ* are different. For example, *t_{b}* is greater than *lₛ*.

Figure 6 illustrates a cross-sectional view of the first embodiment after depositing first liner material 330 over phase change material 320. In one implementation, first liner material 330 can include at least one of Ti, TiN, or TaN. Other implementations for first liner material 330 include any other suitable liner material. First liner material 330 is deposited using CVD, HDP-CVD, ALD, MOCVD, PVD, JVD, or other suitable deposition technique.

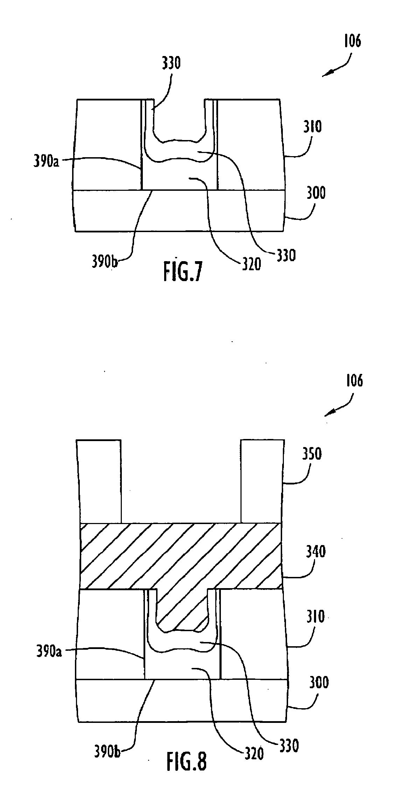

Figure 7 illustrates a cross-sectional view of the first embodiment after removing a portion of first liner material 330 and a portion of phase change material 320. In one implementation, planarizing is used for removing. In another implementation, chemical mechanical planarization (CMP) is used to remove a portion of first liner material 330 and a portion of phase change material 320. In another implementation, the structure illustrated in Figure 6 is filled with a support material before removing a portion of first liner material 330 and a portion of phase change material 320. Support materials include amorphous silicon (aSi), SiO₂, SiOₓ, SiN, FSG, BPSG, BSG, or other suitable materials. In one implementation, the support material is removed after removing a portion of first liner material 330 and a portion of phase change material 320.

Figure 8 illustrates a cross-sectional view of the first embodiment after depositing second insulator material 340 and mask material 350 and after structuring mask material 350. Second insulator material 340 includes SiO₂, SiOₓ, SiN, FSG, BPSG, BSG, or other suitable materials. Second insulator material 340 is deposited using CVD, HDP-CVD, ALD, MOCVD, PVD, JVD, or other suitable deposition technique. Mask material 350 is used for protecting parts of the underlying insulator material 340 which should not be removed. Mask material 350 includes resists, anti-reflective coatings (ARC), hard masks, or other suitable mask materials. Mask material 350 is structured by etching which includes plasma etching or wet etching processes. Insulator material 340 is structured utilizing structured mask material 350. Structuring insulator material 340 includes plasma etching or wet etching processes. Insulator material 340 includes SiO₂, SiOₓ, SiN, FSG, BPSG, BSG, or other suitable material.

After the removal of insulator material 340 to expose first liner material 330 the structure is filled by depositing conductor material 360. In one implementation, conductor material 360 includes W. Conductor material 360 can be deposited using CVD, HDP-CVD, ALD, MOCVD, PVD, JVD, or other suitable deposition technique. The structure illustrated in Figure 3 is formed.

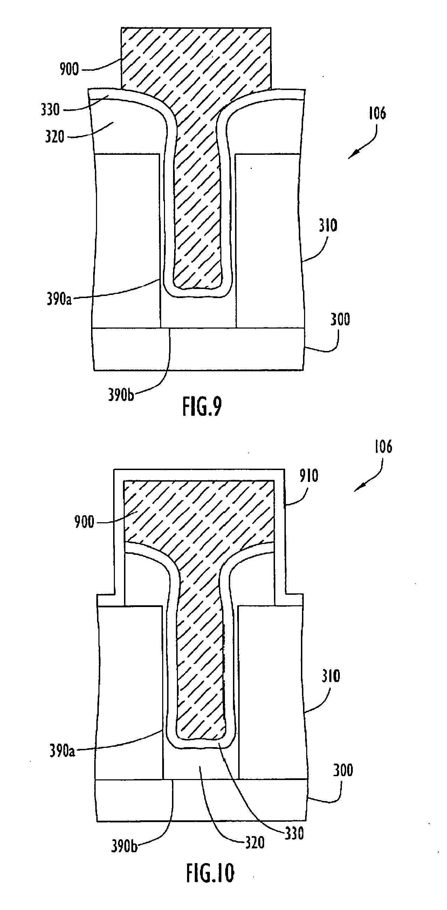

Figure 9 illustrates a cross-sectional view of a second embodiment after depositing and structuring sacrificial material 900. The initial structure before deposition is illustrated in Figure 6. Sacrificial material 900 includes aSi, SiO₂, SiOₓ, SiN, FSG, BPSG, BSG, or other suitable material and is deposited using CVD, HDP-CVD, ALD, MOCVD, PVD, JVD, or other suitable deposition technique. Sacrificial material 900 is structured by plasma etching or wet etching processes applying aforementioned mask techniques.

The structured sacrificial material 900 itself is used as mask to structure the exposed first liner material 330 and underlying phase change material 320. In other implementations, any suited etch process with suitable anisotropic etching behavior like plasma etching or wet etching processes is utilized to etch the liner material 330 and underlying phase change material 320. No planarization technique is applied for the removal of phase change material 320.

Figure 10 illustrates a cross-sectional view of the second embodiment after depositing second liner material 910. Second liner material 910 includes SiO₂, SiOₓ, SiN, FSG, BPSG, BSG, or other suitable material and is deposited using CVD, HDP-CVD, ALD, MOCVD, PVD, JVD, or other suitable deposition technique. Second liner material 910 encapsulates phase change material 320. Second insulator material 920 is deposited using CVD, HDP-CVD, ALD, MOCVD, PVD, JVD, or other suitable deposition technique. Second insulator material 920 includes SiO₂, SiOₓ, SiN, FSG, BPSG, BSG, or other suitable material.

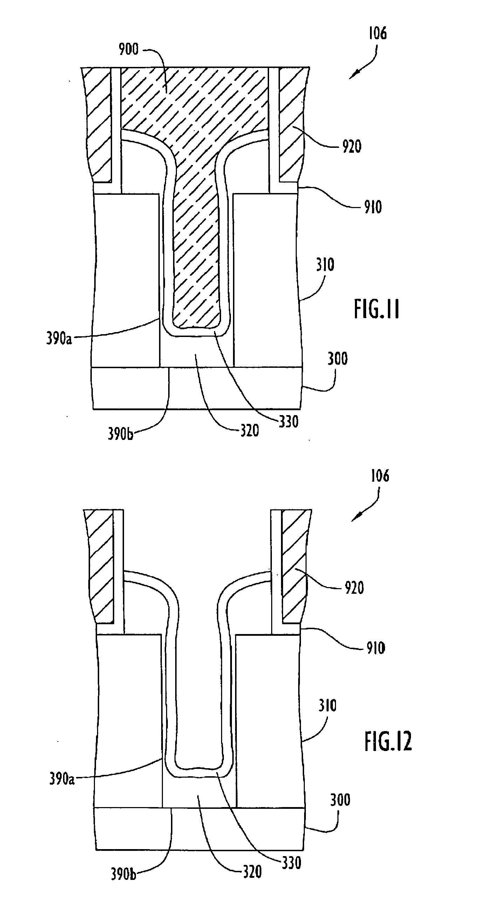

Figure 11 illustrates a cross-sectional view of the second embodiment after removing a portion of second liner material 910 and a portion of second insulator material 920. In one implementation, planarizing is used for removing. In another implementation, chemical mechanical planarization (CMP) is used to remove a portion of second liner material 910 and a portion of second insulator material 920.

Figure 12 illustrates a cross-sectional view of the second embodiment after removing sacrificial material 900. Sacrificial material 900 is removed to expose the inner part of the void. In one implementation, wet etch techniques are used for the removal.

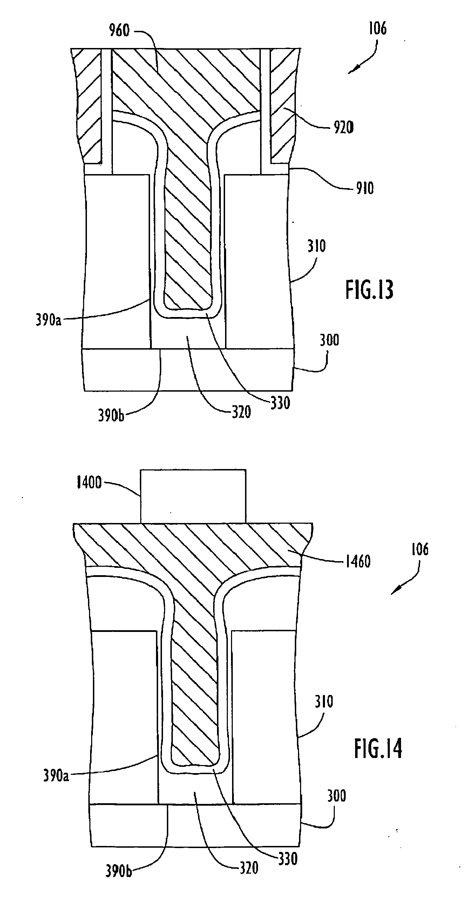

Figure 13 illustrates a cross-sectional view of the second embodiment after depositing conductor material 960. The structure illustrated in Figure 12 is filled by depositing conductor material 960. In one implementation, conductor material 960 includes W. Conductor material 960 is deposited using CVD, HDP-CVD, ALD, MOCVD, PVD, JVD, or other suitable deposition technique.

Figure 14 illustrates a cross-sectional view of a third embodiment after depositing conductor material 1460 and after depositing and structuring of mask material 1400. The initial structure before deposition of conductor material 1460 is illustrated in Figure 6. In one implementation, conductor material 1460 includes W. Conductor material 1460 is deposited using CVD, HDP-CVD, ALD, MOCVD, PVD, JVD, or other suitable deposition technique. Mask material 1400 is structured by plasma etching or wet etching processes applying aforementioned mask techniques.

Using mask material 1400 to shadow and protect parts of the structure which are not to be removed first liner material 330 and underlying phase change material 320 are removed. In other implementations, any suited etch process with suitable anisotropic etching behavior like plasma etching or wet etching processes is utilized to etch the liner material 330 and underlying phase change material 320. No planarization technique is applied for the removal of phase change material 320.

Second liner material 1410 can be deposited using CVD, HDP-CVD, ALD, MOCVD, PVD, JVD, or other suitable deposition technique. Second liner material 1410 includes SiO₂, SiOₓ, SiN, FSG, DPSG, BSG, or other suitable material. Second insulator material 1420 is deposited using CVD, HDP-CVD, ALD, MOCVD, PVD, JVD, or other suitable deposition technique. Second insulator material 1420 includes SiO₂ SiOₓ, SiN, FSG, BPSG, BSG, or other suitable material.

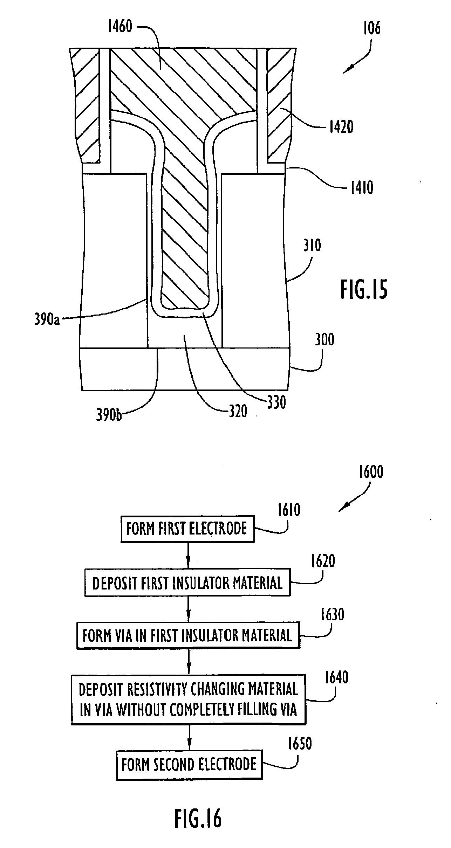

Figure 15 illustrates a cross-sectional view of the third embodiment after removing a portion of second liner material 1410 and a portion of second insulator material 1420.

Significant operations performed in accordance with the described embodiments of the present invention are summarized in the functional flow diagram 1600 shown in Figure 15. In operation 1610, the first electrode is formed. In operation 1620, the first insulator material is deposited. Next, in operation 1630, the via is formed in the first insulator material. In operation 1640, the resistivity changing material is deposited in the via without completely filling the via. A void in the resistivity changing material is formed lying within the via. Finally, in operation 1650, the second electrode is formed. During forming the second electrode phase change material has to be removed. Some embodiments of the presented invention illustrate the removing of the phase change material without planarization techniques.

While the specific embodiments described herein substantially focused on using phase change memory elements, the present invention can be applied to any suitable type of resistivity changing memory elements.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A method to manufacture a memory cell (100), the method comprising:
forming a first electrode (300);
depositing a first insulator material (310);
forming a via (390) in the first insulator material (310);
depositing a resistivity changing material (320) in the via (390) without completely filling the via (390); and
forming a second electrode (360) contacting the resistivity changing material (320).

2. The method of claim 1, wherein the resistivity changing material (320) is deposited with a greater thickness at the bottom part of the via (390b) than at the sidewall of the via (390a).

3. The method of claims 1 or 2, wherein the via (390) is formed with angled side walls.

4. The method of claims 1 to 3, wherein the via (390) is formed with an aspect ratio of greater than 1.5.

5. The method of claims 1 to 4, further comprising:
depositing a first liner material (330) over the resistivity changing material (320)_{.}

6. The method of claim 5, wherein the first liner material (330) comprises at least one of Ti, TiN, or TaN.

7. The method of claims 1 to 6, wherein forming the second electrode (360) further comprises:
removing a portion of the resistivity changing material (320) to expose the first insulator material (310) and the resistivity changing material (320);
depositing a second insulator material (340) over the exposed portion of the first insulator material (310) and the resistivity changing material (320);
structuring the second insulator material (340) to expose the resistivity changing material (320); and
depositing a conductor material (360) to provide the second electrode.

8. The method of claim 7, wherein removing a portion of the resistivity changing material (320) to expose the first insulator material (310) and the resistivity changing material (320) includes planarizing.

9. The method of claims 7 or 8, wherein depositing the conductor material (360) comprises depositing W.

10. The method of claims 1 to 9, wherein depositing the first insulator material (310) over the first electrode (300) comprises depositing one of SiO₂, SiOₓ, SiN, FSG, BPSG, or BSG.

11. The method of claims 1 to 10, wherein forming the second electrode (360) further comprises:
removing the resistivity changing material (320) without planarizing it.

12. The method of claims 11, wherein forming the second electrode (360) further comprises:
depositing a sacrificial material (900) over the resistivity changing material (320);
structuring the sacrificial material (900) to expose a portion of the resistivity changing material (320);
depositing a second liner material (910) over the sacrificial material (900) and the first insulator material (310);
depositing a second insulator material (920) over the second liner material (910);
removing a portion of the second liner material (910) and of the second insulator material (920) to expose the sacrificial material (900);
removing the sacrificial material (900); and
depositing a conductor material (960) to provide the second electrode (360).

13. The method of claims 11 or 12, further comprising:
depositing a conductor material (1460) over the resistivity changing material (320);
removing a portion of the conductor material (1460);
depositing a second liner material (1410) over the exposed portion of the first insulator material (310) and over the exposed conductor material (1460);
depositing a second insulator material (1420) over the second liner (1410);
removing a portion of the second liner material (1410) and a portion of the second insulator material (1420) to expose the conductor material (1460).

14. The method of claims 1 to 13, wherein depositing a resistivity changing material (320) comprises depositing phase change material.
